# EUROPEAN PATENT SPECIFICATION

(11) **EP 4 496 146 B1**
(45) Date of publication and mention of the grant of the patent: **02.09.2026**
(21) Application number: 23769762.8
(22) Date of filing: 14.03.2023
(51) Int. Cl.: H01R 31/06, H01R 13/73, B60L 53/16, B60L 53/18, B60L 53/302

(54) **CONNECTOR ASSEMBLY HAVING LIQUID COOLING FUNCTION, AND VEHICLE**
VERBINDERANORDNUNG MIT FLÜSSIGKEITSKÜHLFUNKTION UND FAHRZEUG
ENSEMBLE RACCORD À FONCTION DE REFROIDISSEMENT PAR LIQUIDE ET VÉHICULE

(30) Priority: 14.03.2022 CN 202210250059
(43) Date of publication of application: 22.01.2025
(73) Proprietor: Changchun Jetty Automotive Technology Co., Ltd., Changchun City, Jilin Province 130000 (CN)
(72) Inventor: WANG, Chao, Changchun, Jilin 130000 (CN)
(74) Representative: Habermann, Hruschka & Schnabel
(86) International application number: PCT/CN2023/081324
(87) International publication number: WO 2023/174260

(56) References cited:
- WO-A1-2021/147872
- CN-A- 111 129 856
- CN-A- 111 200 200
- CN-A- 114 709 689
- CN-U- 211 088 574
- CN-U- 211 294 720
- CN-U- 212 304 003
- CN-U- 212 304 003
- CN-U- 214 899 244
- CN-U- 218 334 622
- GB-A- 2 568 079
- US-A- 5 591 937

## Description

### RELATED APPLICATION

The present disclosure claims priority to Chinese Patent Application No. 202210250059.0, entitled "connector assembly having liquid cooling function, and vehicle", and filed to the China National Intellectual Property Administration on March 14, 2022.

### TECHNICAL FIELD

The present disclosure relates to the technical field of vehicle electrical appliances, and particularly to a connector assembly having a liquid cooling function, and a vehicle.

### BACKGROUND

With the increasing popularity of new energy vehicles, the equipment and facilities for conducting current for the new energy vehicles have also been developed. Since a connector assembly on a new energy vehicle has to meet the requirement of driving a high-power motor, the transmission current is large, and the diameter of a high-voltage cable on the connector assembly also increases, such that the assembling on a vehicle body can only adopt manual mounting, which causes the wastes of a labor cost and a time cost.

In addition, during normal use, a very large current flows through the high-voltage cable, such that a lot of heat is generated in both the high-voltage cable and a connector. A high temperature will occur due to excessive heat, and the connection position of the high-voltage cable and the surrounding connectors and fasteners will be failed due to the high temperature, which will affect the normal use of a high-voltage device, resulting in short circuit and open circuit, and even the danger of electric shock that is life-threatening.

The high voltage cable will produce strong electromagnetic interference due to the large current. In order to reduce the influence of the electromagnetic interference, the high-voltage cable usually uses a shielding net to shield the electromagnetic interference. At present, the conventional shielding net is braided with metal wires, and it is necessary to add a shielding braiding machine in the cable production equipment, such that the equipment price is high and a large area is occupied, resulting in a high price of the shielding cable of the connector. In addition, the shielding technology for the connector is not perfect enough at present, such that the electrical appliances in the vehicle are interfered with and cannot be used. Conventional connector assemblies are known from the prior art, for example from CN212304003U, US5591937A, and WO2021147872A1.

Currently, there is no practical solution to the above problems. Therefore, the technical field of vehicle electrical appliances is in urgent need of a connector assembly with a small wire diameter and a low cable heat generation amount, which can realize automatic production and assembling.

### SUMMARY

The present disclosure aims to provide new technical solutions of a connector assembly having a liquid cooling function and a vehicle. The connector assembly having a liquid cooling function of the present disclosure can reduce the failures of an electrical connection framework and a connection terminal caused by a high temperature during electrification, decrease the diameter of the electrical connection framework, prolong a service life of a connector, improve the safety of the whole vehicle, while shielding the electromagnetic interference.

The invention is limited by and defined in the independent claim. Among the other features of the independent claim, there is provided a connector assembly having a liquid cooling function, including at least one electrical connection framework and connectors. Each connector includes a connection terminal, two ends of the electrical connection framework are electrically connected to the connection terminals respectively. The electrical connection framework is provided with a hollow inner cavity, and an outer periphery of the electrical connection framework is sleeved with a protective shell having shielding effectiveness. A cavity is formed between the outer periphery of the electrical connection framework and an inner wall of the protective shell having shielding effectiveness, and a cooling liquid flows through the hollow inner cavity and the cavity.

Optionally, the cooling liquid is made of an insulating material.

According to the invention the electrical connection framework includes a rigid hollow conductor.

Optionally, an annular cross-sectional area of the electrical connection framework is 1.5 mm² to 240 mm².

Optionally, the electrical connection framework is electrically connected to the connection terminal by means of welding or crimping.

Optionally, a material of the protective shell contains a rigid conductive material.

Optionally, a material of the protective shell contains metal or conductive plastic.

According to the invention the connector further includes a shielding inner shell, and a material of the shielding inner shell contains a conductive material.

Optionally, a material of the shielding inner shell contains metal or conductive plastic.

Optionally, the conductive plastic is a polymer material containing conductive particles, and the conductive particles are made of a material containing one or more selected from the group consisting of metal, conductive ceramics, a carbon-containing conductor, a solid electrolyte and a mixed conductor. The polymer material contains one or more selected from the group consisting of tetraphenyl ethylene, polyvinyl chloride, polyethylene, polyamide, polytetrafluoroethylene, tetrafluoroethylene/hexafluoropropylene copolymer, ethylene/tetrafluoroethylene copolymer, polypropylene, polyvinylidene fluoride, polyurethane, polyterephthalic acid, polyurethane elastomer, styrene block copolymer, perfluoroalkoxy alkane, chlorinated polyethylene, polyphenylene sulfide, polystyrene, cross-linked polyolefin, ethylene-propylene rubber, ethylene/vinyl acetate copolymer, chloroprene rubber, natural rubber, styrene butadiene rubber, nitrile rubber, silicone rubber, butadiene rubber, isoprene rubber, ethylene propylene rubber, chloroprene rubber, butyl rubber, fluororubber, polyurethane rubber, polyacrylate rubber, chlorosulfonated polyethylene rubber, epichlorohydrin rubber, chlorinated polyethylene rubber, chlorosulfide rubber, styrene butadiene rubber, butadiene rubber, hydrogenated nitrile rubber, polysulfide rubber, crosslinked polyethylene, polycarbonate, polysulfone, polyphenyl ether, polyester, phenolic resin, urea formaldehyde, styrene-acrylonitrile copolymer, polymethacrylate, and polyoxymethylene resin.

Optionally, a material of the metal contains one or more selected from the group consisting of nickel, cadmium, zirconium, chromium, cobalt, manganese, aluminum, tin, titanium, zinc, copper, silver, gold, phosphorus, tellurium and beryllium.

Optionally, the carbon-containing conductor contains one or more selected from the group consisting of graphite silver, graphene silver, graphite powder, a carbon nanotube material and a graphene material.

Optionally, the protective shell is electrically connected to the shielding inner shell by means of crimping or welding.

Optionally, an impedance between the protective shell and the shielding inner shell is less than 80 mΩ.

Optionally, a transfer impedance of the protective shell is less than 100 mΩ.

Optionally, a transfer impedance of the shielding inner shell is less than 100 mΩ.

Optionally, the connector includes a first connector and a second connector which are connected to two ends of the electrical connection framework, and the first connector is internally provided with a rotary cavity communicated with the cavity and the hollow inner cavity. The second connector is internally provided with an adapter cavity communicated with the cavity, the electrical connection framework is provided with an inlet pipe communicated with the hollow inner cavity, and the second connector is provided with an outlet pipe communicated with the adapter cavity.

Optionally, a part of the electrical connection framework inside the rotary cavity is radially provided with a through hole, via which the cooling liquid flows through the hollow inner cavity and the rotary cavity.

Optionally, a part of the electrical connection framework inside the adapter cavity is radially provided with a connection hole, into which the inlet pipe is inserted and communicated with the hollow inner cavity, and the inlet pipe passes through an outer wall of the second connector and protrudes out of the second connector.

Optionally, a first sealing structure is disposed between the inlet pipe and the second connector and between the outlet pipe and the second connector.

Optionally, a second sealing structure is disposed between the connector and the protective shell.

Optionally, the cavity is internally provided with at least one supporting ring, an inner wall of which is in contact with the outer periphery of the electrical connection framework, and an outer wall of which is in contact with the inner wall of the protective shell.

Optionally, the supporting ring is provided with at least one axial through hole in an axial direction of the electrical connection framework.

Optionally, a sum of cross-sectional areas of the axial through holes accounts for 20% to 90% of a cross-sectional area of the cavity.

Optionally, the electrical connection framework has a bent position, and at least two ends and a middle position of the arc shape are provided with the supporting rings, respectively.

Optionally, a thickness of the protective shell accounts for 1% to 15% of an outer diameter of the protective shell.

Optionally, an outer diameter of the cavity is 1.02 to 1.3 times that of the electrical connection framework.

Optionally, a boiling point of the cooling liquid is greater than or equal to 100°C.

Optionally, the cooling liquid is one or more selected from the group consisting of ethylene glycol, silicone oil, fluoride, castor oil, coconut oil, corn oil, cottonseed oil, linseed oil, olive oil, palmitic acid, peanut oil, grapeseed oil, rapeseed oil, safflower oil, sunflower oil, soybean oil, high oleic acid variants of various vegetable oils, decen-4-oic acid, decenoic acid, lauroleic acid, linderic acid, tetradecenoic acid, physeteric acid, tsuduic acid, palmitoleic acid, petroselic acid, oleic acid, octadecenoic acid, gadoleic acid, gondoic acid, cetoleic acid, erucic acid, nervonic acid, glycerin, transformer oil, axle oil, internal combustion engine oil or compressor oil.

Optionally, a cooling rate of the cooling liquid to the electrical connection framework is 0.04 K/s to 6 K/s.

Optionally, one of the connectors is a charging cradle.

Optionally, a partial region of the electrical connection framework is flexible.

Optionally, the electrical connection framework includes at least one bent portion.

According to a second aspect of the present disclosure, there is further provided a vehicle, including the connector assembly having a liquid cooling function according to any one of the above embodiments, a circulating pump and a cooling device. The cavity and the hollow inner cavity are communicated with the circulating pump and the cooling device.

Optionally, an inlet pipe in communication with the hollow inner cavity is communicated with a liquid inlet of the circulating pump, a liquid outlet of the circulating pump is communicated with a liquid inlet of the cooling device, and an outlet pipe in communication with the hollow inner cavity is communicated with a liquid outlet of the cooling device.

The present disclosure has the following advantageous effects:
1. The present disclosure solves the problem that the wire diameter of the high-voltage wire harness at present is large. The liquid cooling technology is used to reduce the heat generation amount of the electrical connection framework, so that the electrical connection framework can conduct a large current with a small wire diameter.
2. The present disclosure solves the problem that the automatic production and assembling cannot be realized due to the use of flexible cables for the high-voltage wire harnesses at present. The automatic fitting and assembling of the wire harness can be realized using the electrical connection framework which is at least partially rigid.
3. The present disclosure solves the problem of the low cooling efficiency of the liquid-cooled wire harness at present. The liquid-cooled wire harness is cooled through a liquid-cooled pipe at present, while in the present disclosure, the cooling liquid directly contacts the electrical connection framework, so that the temperature of the electrical connection framework can be quickly decreased, and a high current conduction can be realized.
4. The present disclosure solves the problem that the flexible cable contacts and rubs the vehicle shell, which cause the damage and short circuit of the insulation layer. The electrical connection framework can be arranged according to the shape of the vehicle body, while keeping a distance from the vehicle body to avoid rubbing the vehicle shell, thereby ensuring the service life of the electrical connection framework.
5. The connector is provided with a shielding inner shell, which can effectively prevent the electromagnetic interference generated by the terminal of the connector. The shielding inner shell made of conductive plastic can be integrally formed with the connector by means of integral injection molding, which saves the machining time, improves the production efficiency and reduces the production cost.
6. The electrical connection framework includes a flexible portion and a bent portion, so that the structure of the connector assembly can be reasonably designed according to the mounting environment of the vehicle body, which makes the mounting of the connector assembly on the vehicle body easier and saves the assembling time.
7. The sealing ring can prevent the leakage of the cooling liquid at the joint, and support the cavity (i.e., cooling cavity) formed between the electrical connection framework and the protective shell, so as to prevent the cavity from being squeezed and deformed under an external force and affecting the circulation of the cooling liquid.
8. The electrical connection framework is sleeved with the protective shell, which not only constructs the cavity (i.e., cooling cavity), but also serves as a shielding layer to effectively shield the electromagnetic interference generated by the electrification of the electrical connection framework.

Other features and advantages of the present disclosure will become clear from the following detailed description of the exemplary embodiments of the present disclosure made with reference to the drawings.

### BRIEF DESCRIPTION OF THE DRAWINGS

The drawings, which are incorporated in and constitute a part of the specification, illustrate the embodiments of the present disclosure and together with the description, serve to explain the principles of the present disclosure.
FIG. 1 illustrates a structural diagram of a connector assembly having a liquid cooling function according to the present disclosure.
FIG. 2 illustrates a structural diagram of a connection between an electrical connection framework and a second connector of a connector assembly having a liquid cooling function according to a first embodiment of the present disclosure.
FIG. 3 illustrates a structural diagram of a connection between an electrical connection framework and a first connector of a connector assembly having a liquid cooling function according to the first embodiment of the present disclosure.
FIG. 4 illustrates a cross-sectional view of an electrical connection framework of a connector assembly having a liquid cooling function according to the present disclosure.
FIG. 5 illustrates a structural diagram of a connection between an electrical connection framework and a second connector of a connector assembly having a liquid cooling function according to a second embodiment of the present disclosure.
FIG. 6 illustrates a structural diagram of a connection between an electrical connection framework and a first connector of a connector assembly having a liquid cooling function according to the second embodiment of the present disclosure.
FIG. 7 illustrates a structural diagram of a supporting ring of a connector assembly having a liquid cooling function according to the present disclosure.
FIG. 8 illustrates a structural diagram of an axial through hole in a supporting ring of a connector assembly having a liquid cooling function according to the present disclosure.

Reference numerals of the main components:
11-first connector; 12-second connector; 2-electrical connection framework; 3-hollow inner cavity; 4-shielding inner shell; 5-protective shell; 6-cavity; 7-connection terminal; 8-sealing ring; 91-inlet pipe; 92-outlet pipe; 93-through hole; 94-rotary cavity; 95-adapter cavity; 10-supporting ring; 101-axial through hole.

### DETAILED DESCRIPTION OF THE EMBODIMENTS

Various exemplary embodiments of the present disclosure will now be described in detail with reference to the drawings. It should be noted that the relative arrangements, the numerical expressions and the numerical values of components and steps set forth in these embodiments do not limit the scope of the present disclosure unless otherwise specified.

The following description of at least one exemplary embodiment is merely illustrative and is in no way intended to limit the present disclosure or the application or the use thereof.

Technologies, methods and devices known to those of ordinary skill in the art may not be discussed in detail, but they should be regarded as parts of the specification under appropriate circumstances.

In all examples illustrated and discussed here, any specific value should be interpreted as illustrative only rather than limiting. Thus, other examples of the exemplary embodiments may have different values.

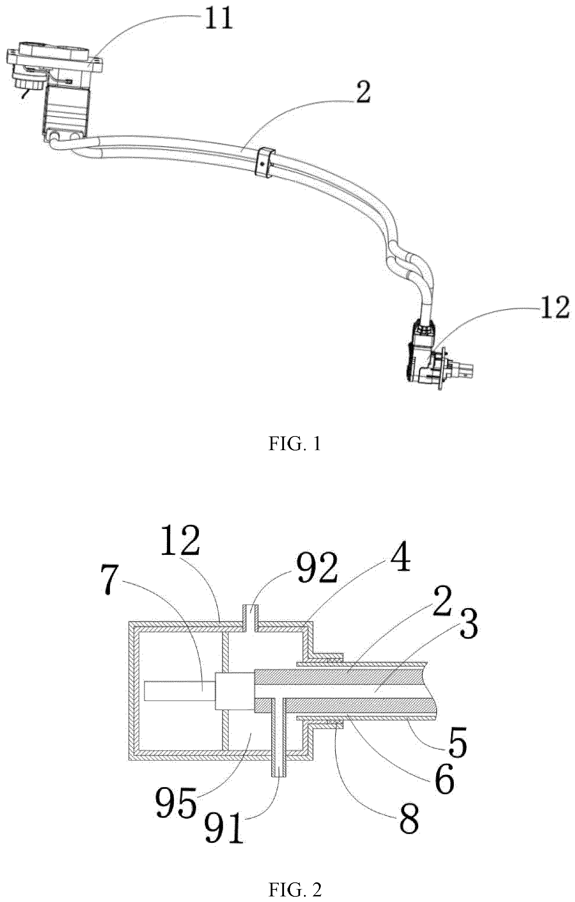

A connector assembly having a liquid cooling function, as illustrated in FIGS. 1 to 8, includes at least one electrical connection framework 2 and connectors, and the connectors may include, for example, a first connector 11 and a second connector 12. Each connector includes a connection terminal 7, and two ends of the electrical connection framework 2 are electrically connected to the connection terminals 7 respectively. In some embodiments, both the first connector 11 and the second connector 12 include the connection terminal 7, and two ends of each of the electrical connection frameworks 2 are electrically connected to the connection terminal 7 respectively. The electrical connection framework 2 is provided with a hollow inner cavity 3, and an outer periphery of the electrical connection framework 2 is sleeved with a protective shell 5 having shielding effectiveness. A cavity 6 is formed between the outer periphery of the electrical connection framework 2 and an inner wall of the protective shell 5 having shielding effectiveness. The hollow inner cavity 3 and the cavity 6 have cooling liquid flowing therethrough. Exemplarily, the cooling liquid is made of an insulation material.

In some embodiments, the cooling liquid is one or more selected from the group consisting of ethylene glycol, silicone oil, fluoride, castor oil, coconut oil, corn oil, cottonseed oil, linseed oil, olive oil, palmitic acid, peanut oil, grapeseed oil, rapeseed oil, safflower oil, sunflower oil, soybean oil, high oleic acid variants of various vegetable oils, decen-4-oic acid, decenoic acid, lauroleic acid, linderic acid, tetradecenoic acid, physeteric acid, tsuduic acid, palmitoleic acid, petroselic acid, oleic acid, octadecenoic acid, gadoleic acid, gondoic acid, cetoleic acid, erucic acid, nervonic acid, glycerin, transformer oil, axle oil, internal combustion engine oil or compressor oil.

At present, the high-voltage cables on most of the connector assemblies use multi-core copper cables, which are heavy and expensive and become an obstacle to the popularization of new energy vehicles. In addition, although the multi-core cable is soft and can be easily machined and wired, the wire diameter is too large and the weight is heavy. During travelling of the vehicle, the cable will frequently rub the vehicle shell, thereby damaging the insulation layer of the cable and resulting in a high-voltage discharge, which will damage the vehicle or cause serious traffic accidents in severe cases.

Aluminum has become one of the main materials to replace the copper cable because the electrical conductivity of aluminum is second only to that of copper, and the aluminum resources have a large storage capacity and a low price. In addition, the multi-core cable structure may be replaced by the cable form of the electrical connection framework 2, such that the cable can be fixed on the vehicle shell, without rubbing the vehicle shell along with the vibration of the vehicle, thereby prolonging the service life of the connector assembly and reducing the accident rate.

However, since the electrical conductivity of the aluminum cable is not as good as that of the copper cable, it is necessary to increase the cross-sectional area of the cable to ensure the normal current value. As a result, the diameter of the aluminum cable is larger, which occupies a larger space during machining and mounting.

The electrical connection framework 2 is connected to the first connector 11 and the second connector 12, and the second connector 12 is connected to a vehicle-mounted battery, thereby completing an electrical transmission from the first connector 11 to the vehicle-mounted battery. When the vehicle is charged, the current flowing through the electrical connection framework 2 is very large, leading to a rapid increase in the temperature of the electrical connection framework 2. The electrical connection framework 2 is provided with the hollow inner cavity 3, and the cooling liquid flows through the cavity 6 (also called a cooling cavity) located between the protective shell 5 and the electrical connection framework 2 and through the hollow inner cavity 3 to cool the electrical connection framework 2, thereby reducing the temperature of the electrical connection framework 2 which generates heat, and enabling the connector assembly to work at a safe temperature. In addition, the diameter of the electrical connection framework 2 is allowed to be decreased, so as to reduce the space occupied by the connector assembly in the vehicle.

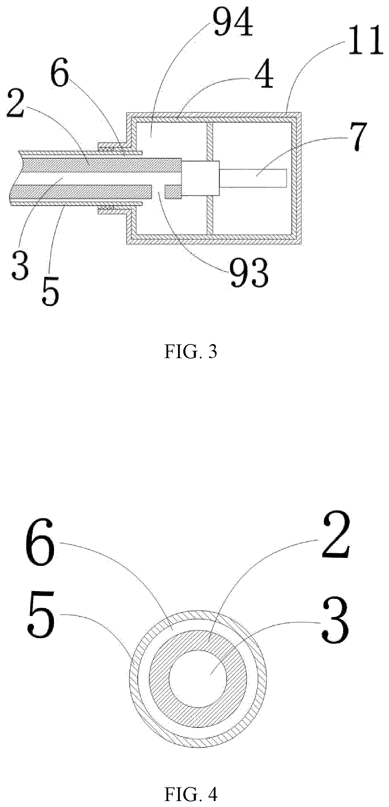

In some embodiments, as illustrated in FIG. 4, an annular cross-sectional area of the electrical connection framework 2 is 1.5 mm² to 240 mm². The cross-sectional area of the electrical connection framework 2 determines the magnitude of the current that can be conducted by the electrical connection framework 2. Generally, the electrical connection framework 2 that realizes signal conduction has a small current and a small cross-sectional area. For example, a minimum cross-sectional area of the electrical connection framework 2 of the wires for signal transmission may be 1.5 mm². However, the electrical connection framework 2 that realizes power conduction has a large current and a large cross-sectional area. For example, a maximum cross-sectional area of a conductor of a vehicle battery wire harness may be 240 mm².

In some embodiments, a partial region of the electrical connection framework 2 is flexible. The flexible material may be a multi-core cable, or a braided cable, or a soft bar formed with a plurality of layers of sheets which are stacked. The flexible material is easy to be bent and has excellent electrical conductivity; the sheet is soft, easy to be deformed and suitable to be used as a flexible conductor; and the stacking of the plurality of layers of sheets ensures not only the flexibility but also the electrification efficiency. The electrical connection framework 2 is formed by connecting the rigid material and the flexible material, so as to better fit the contour of the vehicle body and save materials and space.

In some embodiments, the electrical connection framework 2 includes at least one bent portion. Therefore, the bent portion may be disposed according to the specific requirements in the wiring process, so as to facilitate the wiring by the operator.

In some embodiments, the first connector 11 and the second connector 12 further include a shielding inner shell 4 made of a material containing a conductive material. In order to reduce the influence of the electromagnetic interference, the conductive cable usually uses a shielding net to shield the electromagnetic interference. At present, the conventional shielding net is braided with metal wires, and it is necessary to add a shielding braiding machine in the cable production equipment, such that the equipment price is high and a large area is occupied, resulting in a high price of the shielding cable of the connector. In the present disclosure, the shielding inner shell 4 made of a conductive material is electrically connected to the protective shell 5 to form a complete shielding device. The material of the protective shell 5 contains a rigid conductive material. Further, the material of the protective shell 5 may contain metal or conductive plastic. Therefore, the shielding inner shell 4 and the protective shell 5 may serve as a shielding layer to effectively shield the electromagnetic interference caused by the electrification of the electrical connection framework 2, thereby saving the use of the shielding net and reducing the cost of the connector assembly.

Since the electrical connection framework 2 conducts a large current, and the protective shell 5 needs to be electrified in order to achieve the shielding effect, there should be no electrical connection between the electrical connection framework 2 and the protective shell 5, otherwise short circuit will be caused. Therefore, the cooling liquid flowing through the cavity 6 between the electrical connection framework 2 and the protective shell 5 should be insulated, and may be pure cooling liquid or cooling oil. Moreover, the electrical connection framework 2 has the hollow inner cavity 3, so the material of the electrical connection framework 2 may contain a rigid hollow conductor material to form the hollow inner cavity 3. Furthermore, in order to reduce the heating degree of the electrical connection framework 2, there is also a cooling liquid or cooling oil flowing through the hollow inner cavity 3.

Further, the material of the shielding inner shell 4 contains metal or conductive plastic. The conductive plastic may be a polymer material containing conductive particles which include one or more selected from the group consisting of metal, conductive ceramics, a carbon-containing conductor, a solid electrolyte and a mixed conductor. The material of the polymer material includes one or more selected from the group consisting of tetraphenyl ethylene, polyvinyl chloride, polyethylene, polyamide, polytetrafluoroethylene, tetrafluoroethylene/hexafluoropropylene copolymer, ethylene/tetrafluoroethylene copolymer, polypropylene, polyvinylidene fluoride, polyurethane, polyterephthalic acid, polyurethane elastomer, styrene block copolymer, perfluoroalkoxy alkane, chlorinated polyethylene, polyphenylene sulfide, polystyrene, cross-linked polyolefin, ethylene-propylene rubber, ethylene/vinyl acetate copolymer, chloroprene rubber, natural rubber, styrene butadiene rubber, nitrile rubber, silicone rubber, butadiene rubber, isoprene rubber, ethylene propylene rubber, chloroprene rubber, butyl rubber, fluororubber, polyurethane rubber, polyacrylate rubber, chlorosulfonated polyethylene rubber, epichlorohydrin rubber, chlorinated polyethylene rubber, chlorosulfide rubber, styrene butadiene rubber, butadiene rubber, hydrogenated nitrile rubber, polysulfide rubber, crosslinked polyethylene, polycarbonate, polysulfone, polyphenyl ether, polyester, phenolic resin, urea formaldehyde, styrene-acrylonitrile copolymer, polymethacrylate, and polyoxymethylene resin.

The advantage of using the conductive plastic is to facilitate the injection molding, and the user can select the shielding inner shell 4 made of an appropriate material as needed.

Further, the metal in the material of the conductive particles may contain one or more selected from the group consisting of nickel, cadmium, zirconium, chromium, cobalt, manganese, aluminum, tin, titanium, zinc, copper, silver, gold, phosphorus, tellurium and beryllium.

In order to verify the influence of different metal materials on the electrical conductivity of the shielding inner shell 4, the inventor makes samples of the shielding inner shell 4 with metal particles of the same size and different materials to test the electrical conductivity of the shielding inner shell 4. The experimental results are shown in Table 1. In this embodiment, the electrical conductivity of the shielding inner shell 4 greater than 99% is an ideal value.

**Table 1: Influence of metal particles with different materials on the electrical conductivity of the shielding inner shell 4**

| Metals of different materials | | | | | | | | | | | | | | | |
|---|---|---|---|---|---|---|---|---|---|---|---|---|---|---|---|
| Gold | Silver | Copper | Nickel | Titanium | Tin | Aluminum | Cadmium | Zirconium | Chromium | Cobalt | Manganese | Zinc | Tellurium | Beryllium | Palladium |
| Electrical conductivity of the shielding inner shell 4 (%) | | | | | | | | | | | | | | | |
| 99.8 | 99.9 | 99.8 | 99.5 | 99.5 | 99.5 | 99.6 | 99.3 | 99.2 | 99.2 | 99.4 | 99.5 | 99.3 | 99.4 | 99.4 | 99.2 |

As can be seen from Table 1, the electrical conductivity of the conductive plastic made of different selected metal particles is within the range of the ideal value. In addition, phosphorus is a non-metallic material and cannot be directly used as the material of the conductive plating, but it can be added to other metal to form an alloy to improve the conductive and mechanical properties of the metal itself. Therefore, the inventor sets that the material of the metal particles contains one or more selected from the group consisting of nickel, cadmium, zirconium, chromium, cobalt, manganese, aluminum, tin, titanium, zinc, copper, silver, gold, phosphorus, tellurium and beryllium.

Further, the carbon-containing conductor in the material of the conductive particles contains one or more selected from the group consisting of graphite silver, graphene silver, graphite powder, a carbon nanotube material and a graphene material. The graphite powder is a mineral powder with the main component of carbon, which is soft and dark gray and is a very good nonmetallic conductive substance. The carbon nanotube has good electrical conductivity, with a structure the same as the lamellar structure of graphite, so it has good electrical properties. Graphene has extremely high electrical properties. The carbon-containing conductor containing these three materials has high electrical conductivity and good shielding performance, which can well realize the electromagnetic shielding of the electrical connection framework 2.

In some embodiments, the material of the connection terminal 7 contains copper or copper alloy, the material of the electrical connection framework 2 contains aluminum or aluminum alloy, and the electrical connection framework 2 is electrically connected to the connection terminal 7 by means of welding or crimping.

Copper or copper alloy has high electrical conductivity and friction resistance, and at present, the power connection parts of most of the electrical devices are made of copper, so the connection terminal 7 made of copper or copper alloy can be used for plugging and unplugging connection, and the connection terminal 7 can be widely used in various electrical transmission scenarios.

The electrical connection framework 2 made of aluminum or aluminum alloy has the advantages of good rigidity, light weight and high transmission efficiency, and is especially suitable for the transmission of large current.

The connection terminal 7 and the electrical connection framework 2 are connected by welding. The welding modes, which include one or more selected from the group consisting of resistance welding, friction welding, ultrasonic welding, arc welding, laser welding, electron beam welding, pressure diffusion welding and magnetic induction welding, use the concentrated heat energy or pressure to achieve a fusion connection at the contact positions of the connection terminal 7 and the electrical connection framework 2, such that the connection by welding is stable.

In addition, the metal inertia of copper is greater than that of aluminum, and an electrode potential difference between copper and aluminum is 1.9997 V. An electrochemical reaction will occur when the two metals are connected and electrified, which will lead to a gradual oxidation of aluminum wires, reducing the mechanical strength and the electrical conductivity of aluminum wires. Dissimilar materials can be connected by welding, and the conductive effect is better since the contact positions are fused.

The resistance welding refers to a method of welding by passing strong current through a contact point that is between an electrode and a workpiece, to generate heat by a contact resistance.

The friction welding refers to a method of welding by using the heat generated by the friction between the contact surfaces of the workpieces as a heat source, to make the workpieces be plastically deformed under pressure.

The ultrasonic welding is to transmit high-frequency vibration waves to surfaces of two to-be-welded objects, so that the surfaces of the two objects rub against each other under pressure to form a fuse molecular layer.

The arc welding is to convert electric energy into heat energy and mechanical energy that are needed for welding by using electric arc as a heat source and using the physical phenomenon of air discharge, so as to connect metals. The arc welding mainly includes shielded metal arc welding, submerged arc welding and gas shielded welding, etc.

The laser welding is an efficient and precise welding method that uses a laser beam with high energy density as a heat source.

The friction welding refers to a method of welding by using the heat generated by the friction between the contact surfaces of the workpieces as a heat source, to make the workpieces be plastically deformed under pressure.

The electron beam welding method refers to a method of using accelerated and focused electron beam to bombard the welding surface that is placed in vacuum or non-vacuum, to melt the welded workpiece to realize welding.

The pressure welding method is a method of applying pressure to weldments to make binding surfaces of them be in close contact and generate a certain plastic deformation to complete the welding.

The magnetic induction welding refers to that that two to-be-welded workpieces are instantaneously collided with each other at high speed under the action of a strong pulsed magnetic field, so that under the action of high pressure waves, the atoms of the two materials on the material surfaces of the two workpieces can meet within interatomic distance, thus forming a stable metallurgical bond at the interface. The magnetic induction welding is a type of solid-state cold welding that can weld conductive metals with similar or dissimilar properties.

The crimping is a production process in which the electrical connection framework 2 and the connection terminal 7 are assembled and then stamped into a whole using a crimping machine. The crimping has the advantage of mass production, and by adopting an automatic crimping machine, products with a stable quality can be rapidly manufactured in large quantities.

In some embodiments, the protective shell 5 is electrically connected to the shielding inner shell 4 by crimping or welding. Aluminum or aluminum alloy has good electrical conductivity, light weight and low price. The shielding inner shell 4 made of aluminum or aluminum alloy can achieve a good shielding effect and prevent the electromagnetic radiation of the connection terminal 7 and the electrical connection framework 2 from affecting other devices.

The crimping is a production process in which the shielding inner shell 4 and the protective shell 5 are assembled and then stamped into a whole using a crimping machine. The crimping has the advantage of mass production, and by adopting an automatic crimping machine, products with a stable quality can be rapidly manufactured in large quantities.

The welding or crimping is substantially the same as the welding mode for the connection terminal 7 and the electrical connection framework 2, and will not be described in detail.

In some embodiments, an impedance between the protective shell 5 and the shielding inner shell 4 is less than 80 mΩ.

The impedance between the protective shell 5 and the shielding inner shell 4 should be as small as possible, so that the current generated by the shielding inner shell 4 can flow back to an energy source or a grounding position without hindrance. If the impedance between the protective shell 5 and the shielding inner shell 4 is large, a large current will be generated between the protective shell 5 and the shielding inner shell 4, thereby generating a large radiation at the cable joint.

In order to verify the influence of the impedance value between the protective shell 5 and the shielding inner shell 4 on the shielding effects, the inventor selects the electrical connection frameworks 2 with the same specification, the connectors with the same specification, the connection terminals 7 with the same specification, and different impedances between the protective shell 5 and the shielding inner shell 4 to make a series of samples, so as to test the shielding effects respectively. The experimental results are shown in Table 2. In this embodiment, the shielding performance value greater than 40dB is an ideal value

The test method of the shielding performance value is to adopt a test instrument that outputs a signal value (which is a test value 2) to the electrical connection framework 2, and dispose a detection device which detects a signal value (which is a test value 1) outside the electrical connection framework 2. The shielding performance value = the test value 2 - the test value 1.

**Table 2: Influence of the impedance between the protective shell 5 and the shielding inner shell 4 on the shielding performance**

| Test parameter | Impedance between the protective shell 5 and the shielding inner shell 4 (mΩ) | | | | | | | | | | |
|---|---|---|---|---|---|---|---|---|---|---|---|
| | 5 | 10 | 20 | 30 | 40 | 50 | 60 | 70 | 80 | 90 | 100 |
| Shielding performance value (dB) | 76 | 74 | 72 | 66 | 61 | 57 | 52 | 49 | 43 | 32 | 28 |

As can be seen from Table 2, when the impedance value between the protective shell 5 and the shielding inner shell 4 is greater than 80 mΩ, the shielding performance value is less than 40 dB, which does not meet the requirement of the ideal value. However, when the impedance value between the protective shell 5 and the shielding inner shell 4 is less than 80 mΩ, all of the shielding performance values meet the requirement of the ideal value, and the trend is increasingly better. Therefore, the inventor sets the impedance between the protective shell 5 and the shielding inner shell 4 to be less than 80 mΩ.

In some embodiments, the protective shell 5 has a transfer impedance less than 100 mΩ. The transfer impedance is usually used to represent the shielding effect of the protective shell 5. The shielding effect gets better as the transfer impedance decreases. The transfer impedance of the protective shell 5 is defined as a ratio of a differential mode voltage U induced by a shield per unit length to current I_{S} passing through a surface of the shield, that is: Z_{T}=U/I_{S}, so it can be understood that the transfer impedance of the protective shell 5 converts the current thereof into a differential mode interference. The transfer impedance should be as small as possible, i.e., a better shielding performance can be obtained by reducing the differential mode interference.

In order to verify the influence of different transfer impedances of the protective shell 5 on the shielding effects, the inventor selects the electrical connection frameworks 2 with the same specification, the connectors with the same specification, the connection terminals 7 with the same specification, and the protective shells 5 with different transfer impedances to make a series of samples, so as to test the shielding effects respectively. The experimental results are shown in Table 3. In this embodiment, the shielding performance value greater than 40 dB is an ideal value.

The test method of the shielding performance value is to adopt a test instrument that outputs a signal value (which is a test value 2) to the electrical connection framework 2, and dispose a detection device which detects a signal value (which is a test value 1) outside the electrical connection framework 2. The shielding performance value = the test value 2 - the test value 1.

**Table 3: Influence of the transfer impedance of the protective shell 5 on the shielding performance**

| Test parameter | Transfer impedance of the protective shell 5 (mΩ) | | | | | | | | | | |
|---|---|---|---|---|---|---|---|---|---|---|---|
| | 20 | 30 | 40 | 50 | 60 | 70 | 80 | 90 | 100 | 110 | 120 |
| Shielding performance value (dB) | 79 | 76 | 71 | 67 | 63 | 58 | 53 | 46 | 43 | 30 | 26 |

As can be seen from Table 3, when the transfer impedance of the protective shell 5 is greater than 100 mΩ, the shielding performance value of the protective shell 5 is less than 40 dB, which does not meet the requirement of the ideal value. When the transfer impedance of the protective shell 5 is less than 100 mΩ, all of the shielding performance values of the protective shell 5 meet the requirement of the ideal value, and the trend is increasingly better. Therefore, the inventor sets the transfer impedance of the protective shell 5 to be less than 100 mΩ.

In some embodiments, the transfer impedance of the shielding inner shell 4 is less than 100 mΩ. In order to verify the influence of different transfer impedances of the shielding inner shell 4 on the shielding effects, the inventor selects the electrical connection frameworks 2 with the same specification, the connectors with the same specification, the connection terminals 7 with the same specification, and the shielding inner shells 4 with different transfer impedances to make a series of samples, so as to test the shielding effects respectively. The experimental results are shown in Table 4. In this embodiment, the shielding performance value greater than 40dB is an ideal value.

The test method of the shielding performance value is to adopt a test instrument that outputs a signal value (which is a test value 2) to the electrical connection framework 2, and dispose a detection device which detects a signal value (which is a test value 1) outside the shielding inner shell 4. The shielding performance value = the test value 2 - the test value 1.

**Table 4: Influence of the transfer impedance of the shielding inner shell 4 on the shielding performance**

| Test parameter | Transfer impedance of the shielding inner shell 4 (mΩ) | | | | | | | | | | |
|---|---|---|---|---|---|---|---|---|---|---|---|
| | 20 | 30 | 40 | 50 | 60 | 70 | 80 | 90 | 100 | 110 | 120 |
| Shielding performance value (dB) | 79 | 76 | 71 | 66 | 63 | 58 | 55 | 46 | 42 | 31 | 27 |

As can be seen from Table 4, when the transfer impedance of the shielding inner shell 4 is greater than 100 mΩ, the shielding performance value of the shielding inner shell 4 is less than 40 dB, which does not meet the requirement of the ideal value. When the transfer impedance of the shielding inner shell 4 is less than 100 mΩ, all of the shielding performance values of the shielding inner shell 4 meet the requirement of the ideal value, and the trend is increasingly better. Therefore, the inventor sets the transfer impedance of the shielding inner shell 4 to be less than 100 mΩ.

In some embodiments, as illustrated in FIGS. 2 and 3, the electrical connector assembly having a liquid cooling function of the present disclosure includes one electrical connection framework 2, and a first connector 11 and a second connector 12 which are connected to two ends of the electrical connection framework 2; the first connector 11 is internally provided with a rotary cavity 94 communicated with the cavity 6 and the hollow inner cavity 3; the second connector 12 is internally provided with an adapter cavity 95 communicated with the cavity 6, the electrical connection framework 2 is provided with an inlet pipe 91 communicated with the hollow inner cavity 3, and the second connector 12 is provided with an outlet pipe 92 communicated with the adapter cavity 95.

Therefore, driven by a circulating pump, the cooling liquid may enter the hollow inner cavity 3 of the electrical connection framework 2 from one end of the electrical connection framework 2 (such as from the second connector 12) via the inlet pipe 91, and after flowing through the hollow inner cavity 3, return to the cavity 6 between the electrical connection framework 2 and the protective shell 5 via the rotary cavity 94 to realize the circulation between the electrical connection framework 2 and the protective shell 5, flow out of the outlet pipe 92 to be cooled by a cooling system, and enter the hollow inner cavity 3 again driven by the circulating pump, thereby forming a complete cooling cycle.

Specifically, as illustrated in FIG. 3, a part of the electrical connection framework 2 inside the rotary cavity 94 is radially provided with a through hole 93, via which the cooling liquid flows through the hollow inner cavity 3 and the rotary cavity 94.

More specifically, as illustrated in FIG. 2, a part of the electrical connection framework 2 inside the adapter cavity 95 is radially provided with a connection hole (not numbered in the drawings), into which the inlet pipe 91 is inserted and communicated with the hollow inner cavity 3, and the inlet pipe 91 passes through an outer wall of the second connector 12 and protrudes out of the second connector 12.

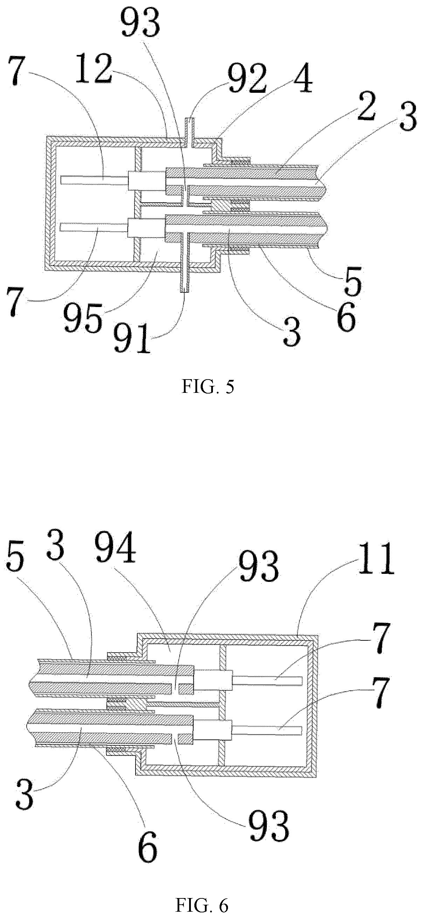

In some embodiments, as illustrated in FIGS. 5 and 6, the electrical connector assembly having a liquid cooling function of the present disclosure includes two electrical connection frameworks 2, and a first connector 11 and a second connector 12 which are connected to two ends of each of the electrical connection frameworks 2. Each of the first connector 11 and the second connector 12 is provided with connection terminals 7 connected to two ends of each of the electrical connection framework 2, respectively. Similarly, the first connector 11 is internally provided with rotary cavities 94, which are separated by a first partition board in correspondence with the number of the electrical connection frameworks 2, and each of the rotary cavities 94 is communicated with the corresponding cavity 6 and hollow inner cavity 3. In this embodiment, the rotary cavity 94 is divided into two parts. The second connector 12 is internally provided with adapter cavities 95, which are separated by a partition board in correspondence with the number of the electrical connection frameworks 2, and the second partition board is provided with a through hole 93, so as to realize the communication between the lower adapter cavity 95 and the hollow inner cavity 3 of the upper electrical connection framework 2 as illustrated in FIG. 5. In addition, in FIG. 5, the lower electrical connection framework 2 is provided with an inlet pipe 91 communicated with the hollow inner cavity 3, and the second connector 12 is provided with an outlet pipe 92 communicated with the upper adapter cavity 95.

Specifically, as illustrated in FIG. 6, the part of each of the two electrical connection frameworks 2 inside the rotary cavity 94 is radially provided with the through hole 93, via which the cooling liquid flows through the hollow inner cavity 3 and the rotary cavity 94.

That is, as illustrated in FIGS. 5 and 6, driven by a circulating pump, the cooling liquid may enter the hollow inner cavity 3 of the electrical connection framework 2 from one end of the lower electrical connection framework 2 in FIG. 5 (such as from the adapter cavity 95 below the second connector 12) via the inlet pipe 91, and after flowing through the hollow inner cavity 3, return to the cavity 6 between the lower electrical connection framework 2 and the protective shell 5 via the lower rotary cavity 94 in FIG. 6 to realize the circulation between the electrical connection framework 2 and the protective shell 5. Next, the cooling liquid may enter the hollow inner cavity 3 of the upper electrical connection framework 2 in FIG. 5 via the through hole 93 of the second partition board, and after flowing through the hollow inner cavity 3, return to the cavity 6 between the upper electrical connection framework 2 and the protective shell 5 via the upper rotary cavity 94 in FIG. 6 to realize the circulation between the electrical connection framework 2 and the protective shell 5, then flow out of the outlet pipe 92 to be cooled by a cooling system, and enter the hollow inner cavity 3 again driven by the circulating pump, thereby forming a complete cooling cycle.

In some embodiments, a first sealing structure may be disposed between the inlet pipe 91 and the second connector 12 and between the outlet pipe 92 and the second connector 12. The first sealing structure may be a sealing ring.

In some embodiments, a second sealing structure is disposed between the connector and the protective shell 5. Specifically, in some embodiments, as illustrated in FIGS. 2 and 3 and FIGS. 5 and 6, a sealing ring 8 (which can be understood as the second sealing structure) is disposed between the first connector 11 or the second connector 12 and the protective shell 5. The sealing ring 8 seals the rotary cavity 94 and the adapter cavity 95. The sealing ring 8 can prevent the cooling liquid from leaking from a joint between the first connector 11 or the second connector 12 and the protective shell 5.

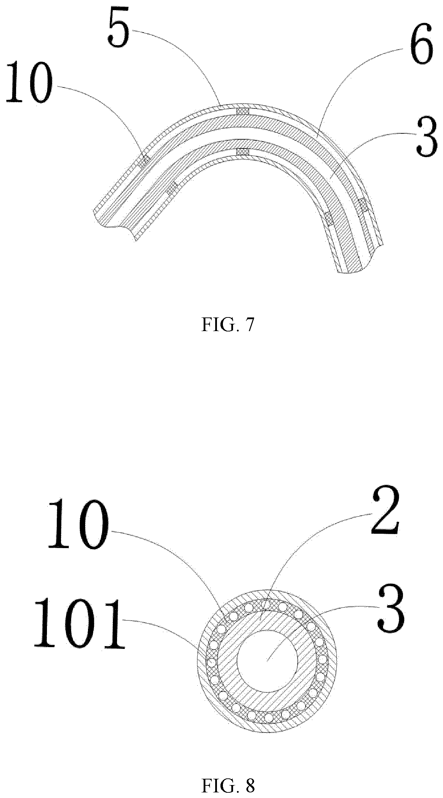

In some embodiments, as illustrated in FIG. 7, the cavity 6 is internally provided with at least one supporting ring 10, an inner wall of which is in contact with the outer periphery of the electrical connection framework 2, and an outer wall of which is in contact with the inner wall of the protective shell 5. The supporting ring 10 may support the cavity 6, prevent the cavity 6 from being narrowed due to an external extrusion and causing the reduction of the cooling efficiency of the connector assembly, while avoiding short circuit caused by the contact between the electrical connection framework 2 and the protective shell 5. A plurality of the supporting rings 10 may be provided, and during machining, each of the supporting rings 10 may be firstly fixed on the electrical connection framework 2, and then sleeved by the protective shell 5 which is extruded so that the outer wall of the supporting rings 10 is in contact with the inner wall of the protective shell 5.

Further, the supporting ring 10 is provided with at least one axial through hole 101 in an axial direction of the electrical connection framework 2. As illustrated in FIG. 8, in order to prevent the cooling efficiency of the connector assembly from being decreased due to the blocking of the cooling liquid by the supporting ring 10, the supporting ring 10 is provided with at least one axial through hole 101 in the axial direction of the electrical connection framework 2, so that the cooling liquid can smoothly pass through the supporting ring 10 and obtain the cooling effect.

Further, a sum of cross-sectional areas of the axial through holes 101 accounts for 20% to 90% of a cross-sectional area of the cavity 6. If the sum of the cross-sectional areas of the axial through holes 101 is too large, the supporting force of the supporting ring 10 will be insufficient, and if the sum of the cross-sectional areas of the axial through holes 101 is too small, the cooling efficiency will be insufficient. In order to select a reasonable sum of the cross-sectional areas of the axial through holes 101, the inventor carries out relevant tests. The experimental method is to select the same electrical connection frameworks 2 with the same cavity 6, dispose the supporting rings 10 with different axial through holes 101 in the cavity 6, apply a force of 80 N to observe whether the cavity 6 is deformed, and it is unqualified if the cavity 6 is deformed. In a closed environment, the same current is conducted to the electrical connection framework 2 with different axial through holes 101, and a temperature rise less than 50K is a qualified value. The results are shown in Table 5.

**Table 5: Influence of the ratio of the sum of the cross-sectional areas of the axial through holes 101 to the cross-sectional area of the cavity 6 on the support to the cavity 6 and the temperature rise of the electrical connection framework 2**

| Ratio of the sum of the cross-sectional areas of the axial through holes 101 to the cross-sectional area of the cavity 6 (%) | | | | | | | | | | | | |
|---|---|---|---|---|---|---|---|---|---|---|---|---|
| 18 | 20 | 30 | 35 | 40 | 50 | 65 | 75 | 82 | 85 | 88 | 90 | 92 |

| Whether the cavity 6 is deformed | | | | | | | | | | | | |
|---|---|---|---|---|---|---|---|---|---|---|---|---|
| No | No | No | No | No | No | No | No | No | No | No | No | Yes |

| Temperature rise of the electrical connection framework (K) | | | | | | | | | | | | |
|---|---|---|---|---|---|---|---|---|---|---|---|---|
| 50.2 | 49.1 | 47.5 | 44 | 41.2 | 39.8 | 38.5 | 37.1 | 33.2 | 30.9 | 27.5 | 26.8 | 26.5 |

As can be seen from Table 5, when the ratio of the sum of the cross-sectional areas of the axial through holes 101 to the cross-sectional area of the cavity 6 is less than 20%, the temperature rise of the electrical connection framework 2 is greater than 50K, which is unqualified. When the ratio of the sum of the cross-sectional areas of the axial through holes 101 to the cross-sectional area of the cavity 6 is greater than 90%, the cavity 6 will be deformed under the force of 80 N, which will easily lead to the decrease of the cooling rate or even the leakage of the cooling liquid. Therefore, the inventor prefers that the ratio of the sum of the cross-sectional areas of the axial through holes 101 to the cross-sectional area of the cavity 6 is 20% to 90%.

In some embodiments, the electrical connection framework 2 has a bent position with an arc-shape portion, and at least two ends and a middle position of the arc-shape portion are provided with the supporting rings 10, respectively. As illustrated in FIG. 7, the arc-shape portion formed by the bent position of the electrical connection framework 2 is more easily extruded, so the supporting rings 10 are disposed at the two ends and the middle position of the arc shape to achieve a better supporting effect.

In some embodiments, a thickness of the protective shell 5 accounts for 1% to 15% of an outer diameter of the protective shell 5. If the thickness of the protective shell 5 is too small, the electrical conductivity is insufficient and the shielding effect cannot meet the requirement. If the thickness of the protective shell 5 is too large, the materials will be wasted and the weight of the vehicle body will be increased. In order to verify the influence of different ratios of the thickness of the protective shell 5 to the outer diameter of the protective shell 5 on the electrical conductivity of the protective shell 5, the inventor makes samples of the protective shell 5 with different thicknesses and the same material, and tests the electrical conductivity respectively. The experimental results are shown in Table 6. In this embodiment, the electrical conductivity of the protective shell 5 not less than 99% is an ideal value.

**Table 6: Influence of different ratios of the thickness of the protective shell 5 to the outer diameter of the protective shell 5 on the electrical conductivity**

| Ratios of different thicknesses of the protective shell 5 to the outer diameter of the protective shell 5 (%) | | | | | | | | | | | | | | |
|---|---|---|---|---|---|---|---|---|---|---|---|---|---|---|
| 0.8 | 1 | 2 | 3 | 4 | 5 | 7 | 9 | 10 | 11 | 12 | 13 | 14 | 15 | 16 |

| Electrical conductivity (%) | | | | | | | | | | | | | | |
|---|---|---|---|---|---|---|---|---|---|---|---|---|---|---|
| 98.9 | 99 | 99 | 99.1 | 99.1 | 99.2 | 99.3 | 99.4 | 99.5 | 99.6 | 99.7 | 99.8 | 99.8 | 99.9 | 99.9 |

As can be seen from Table 6, when the ratio of the thickness of the protective shell 5 to the outer diameter of the protective shell 5 is less than 1%, the electrical conductivity of the protective shell 5 is less than 99%, which is unqualified. When the ratio of the thickness of the protective shell 5 to the outer diameter of the protective shell 5 is greater than 15%, the electrical conductivity has no significant increase, the shielding effect will not be further enhanced, and the thicker protective shell 5 will increase the cost and the weight of the vehicle body. Therefore, the inventor prefers that the thickness of the ratio of the thickness of the protective shell 5 to the outer diameter of the protective shell 5 is 1% to 15%.

In some embodiments, the outer diameter of the cavity 6 is 1.02 to 1.3 times the outer diameter of the electrical connection framework 2. If the cavity 6 has a too small outer diameter, the cooling liquid flowing therethrough is not enough and the cooling efficiency is insufficient. When the electrical connection framework 2 is bent, the cavity 6 will be partially or completely closed, and the cooling liquid cannot flow through to achieve the cooling effect. In order to seek for a suitable relationship between the outer diameter of the cavity 6 and the outer diameter of the electrical connection framework 2, the inventor carries out relevant tests. The test method is to select the samples of the same electrical connection framework 2 and the cavities 6 with different outer diameters, enable same cooling liquid to flow into a group of samples at the same speed, and measure the temperature rise after electrifying the electrical connection framework 2; then measure the temperature rise after bending another group of samples for 90° with a bending radius 3 times the outer diameter of the electrical connection framework 2. The temperature rise less than 50 K is a qualified value. The results are shown in Table 7.

**Table 7: Influence of the ratio of the outer diameter of cavity 6 to the outer diameter of electrical connection framework 2 on the temperature rise of the electrical connection framework**

| Ratio of the outer diameter of cavity 6 to the outer diameter of electrical connection framework 2 | | | | | | | | | | | | |
|---|---|---|---|---|---|---|---|---|---|---|---|---|
| 1.01 | 1.02 | 1.08 | 1.10 | 1.11 | 1.13 | 1.15 | 1.17 | 1.20 | 1.25 | 1.28 | 1.3 | 1.31 |

| Temperature rise of the electrical connection framework (K) | | | | | | | | | | | | |
|---|---|---|---|---|---|---|---|---|---|---|---|---|
| 50.2 | 49 | 47.5 | 44 | 41.2 | 39.8 | 38.5 | 37.1 | 33.2 | 30.9 | 27.5 | 26.8 | 26.8 |

| Temperature rise of the bent electrical connection framework (K) | | | | | | | | | | | | |
|---|---|---|---|---|---|---|---|---|---|---|---|---|
| 66.2 | 57.9 | 49.8 | 48.6 | 44.9 | 43.2 | 41.7 | 39.6 | 37.8 | 35.3 | 30.4 | 29.6 | 29.5 |

As can be seen from Table 7, when the ratio of the outer diameter of the cavity 6 to the outer diameter of the electrical connection framework 2 is less than 1.02, the temperature rise of the electrical connection framework 2 is greater than 50K, which is unqualified; and the temperature rise of the electrical connection framework 2 after being bent is higher because a part of the cavity 6 has been blocked. When the ratio of the outer diameter of the cavity 6 to the outer diameter of the electrical connection framework 2 is greater than 1.3, the temperature rise of the electrical connection framework 2 has no obvious change, and the thicker cavity 6 will increase the cost and the weight of the vehicle body, so the inventor prefers that the outer diameter of the cooling cavity 6 is 1.02 to 1.3 times that of the electrical connection framework 2.

The present disclosure further provides a vehicle, which includes the aforementioned connector assembly having a liquid cooling function, a circulating pump and a cooling device. The cavity 6 and the hollow inner cavity 3 are communicated with the circulating pump and the cooling device. Specifically, in some embodiments, the inlet pipe 91 is communicated with a liquid inlet of the circulating pump, a liquid outlet of the circulating pump is communicated with a liquid inlet of the cooling device, and a liquid outlet of the cooling device is communicated with the outlet pipe 92.

In some embodiments, a cooling medium is cooling gas or cooling liquid. The cooling gas may be refrigerated air. The cooling liquid may be one or more selected from the group consisting of ethylene glycol, castor oil, coconut oil, corn oil, cottonseed oil, linseed oil, olive oil, palmitic acid, peanut oil, grapeseed oil, rapeseed oil, safflower oil, sunflower oil, soybean oil, high oleic acid variants of various vegetable oils, decen-4-oic acid, decenoic acid, lauroleic acid, linderic acid, tetradecenoic acid, physeteric acid, tsuduic acid, palmitoleic acid, petroselic acid, oleic acid, octadecenoic acid, gondoic acid, cetoleic acid, erucic acid, nervonic acid, glycerin, transformer oil, axle oil, internal combustion engine oil or compressor oil. An additive may also be added into the cool liquid, and the additive is selected from one or more of an antioxidant, a pour point inhibitor, a corrosion inhibitor, an antibacterial agent and a viscosity modifier. A boiling point of the cooling liquid may be greater than or equal to 100°C. The cooling oil has the advantages of sensitive heat balance capability, super-strong heat conduction capability, super-wide working temperature range, no boiling, micro-pressure of the cooling system, no addition of antifreeze in a low-temperature environment, and no corrosion damage such as cavitation, liquid scale, electrolysis or the like.

In some embodiments, the cooling rate of the cooling liquid to the electrical connection framework 2 is 0.04 K/s to 6 K/s. In order to verify the influence of the cooling rate of the cooling liquid on the temperature rise of the electrical connection framework 2, the inventor selects ten electrical connection frameworks 2 with the same cross-sectional area, the same material and the same length and conducts the same current thereto, cools the electrical connection frameworks 2 with the cooling liquid of different cooling rates, reads and records the temperature rise of each of the electrical connection frameworks 2 in Table 8.

The experimental method is to conduct the same current, in a closed environment, to each of the electrical connection frameworks 2 which adopts the cooling liquid of different cooling rates, record a temperature before the current conduction and a stable temperature after the current conduction, and take an absolute value of a difference therebetween. In this embodiment, a temperature rise less than 50 K is a qualified value.

**Table 8: Influence of different cooling rates of the cooling liquid on the temperature rise of the connection terminal 7**

| Cooling rate of the cooling structure (K/min) | | | | | | | | | | | | |
|---|---|---|---|---|---|---|---|---|---|---|---|---|
| 0.01 | 0.03 | 0.04 | 0.1 | 0.3 | 0.5 | 1 | 2 | 3 | 4 | 5 | 6 | 7 |

| Temperature rise of the connection terminal (K) | | | | | | | | | | | | |
|---|---|---|---|---|---|---|---|---|---|---|---|---|
| 63.0 | 54.5 | 49.6 | 49.1 | 48.2 | 47.3 | 41.4 | 37.7 | 33.3 | 30.9 | 28.5 | 27.5 | 27.4 |

As can be seen from Table 8, when the cooling rate is less than 0.04 K/s, the temperature rise of the electrical connection framework 2 is unqualified, and the temperature rise of the electrical connection framework 2 decreases as the cooling rate increases. However, when the cooling rate of the cooling liquid is greater than 6 K/s, the temperature rise of the electrical connection framework 2 is not obviously decreased, and a higher cooling rate means a higher price and a more complicated process, so the inventor sets the cooling rate of the cooling structure as 0.04 K/s to 6 K/s.

In some embodiments, one of the connectors is a charging cradle. The two ends of the electrical connection framework 2 are connected to one connector respectively. In some cases, one connector (e.g., the first connector 11) may be a charging cradle that charges the other connector (e.g., the second connector 12) through the electrical connection framework 2.

In some embodiments, a partial region of the electrical connection framework 2 is flexible. A flexible body ensures that the electrical connection framework 2 can be bent at a large angle, so as to be conveniently disposed in the vehicle body with a large corner. Meanwhile, the flexible body can absorb the vibration of the electrical connection framework 2, so that the vibration of the electrical connection framework 2 will not affect the connector and other corresponding electrical devices on the vehicle body.

In some embodiments, the electrical connection framework 2 includes at least one bent portion to meet the requirement of mounting the electrical connection framework 2 on the vehicle body.

The present disclosure further provides a vehicle, which includes the aforementioned connector assembly having a liquid cooling function, a circulating pump and a cooling device, and the hollow inner cavity 3 is communicated with the circulating pump and the cooling device.

More specifically, in some embodiments, the inlet pipe 91 in communication with the hollow inner cavity 3 is communicated with a liquid inlet of the circulating pump, a liquid outlet of the circulating pump is communicated with an liquid inlet of the cooling device, and an liquid outlet of the cooling device is communicated with the outlet pipe 92 which is in communication with the hollow inner cavity 3.

Although some specific embodiments of the present disclosure have been described in detail by examples, it should be understood by those skilled in the art that the above examples are only for illustration rather than limiting the scope of the present disclosure.

Modifications to the disclosed embodiments are possible as long as they fall within the scope of the appended claims. The scope of the present disclosure is defined by the appended claims.

## Claims

1. A connector assembly having a liquid cooling function, comprising at least one electrical connection framework (2) and connectors, wherein each connector comprises a connection terminal, two ends of the electrical connection framework (2) are electrically connected to the connection terminals respectively, the electrical connection framework (2) is provided with a hollow inner cavity (3), an outer periphery of the electrical connection framework (2) is sleeved with a protective shell (5) having electromagnetic shielding effectiveness, a cavity (6) is formed between the outer periphery of the electrical connection framework (2) and an inner wall of the protective shell (5) having electromagnetic shielding effectiveness, and the hollow inner cavity (3) and the cavity (6) are configured to flow a cooling liquid; wherein
the electrical connection framework (2) comprises a rigid hollow conductor;
the connector further comprises a shielding inner shell (4), and a material of the shielding inner shell (4) contains a conductive material;
the protective shell (5) is electrically connected to the shielding inner shell (4) by means of crimping or welding.

2. The connector assembly having a liquid cooling function according to claim 1, wherein the cooling liquid is made of an insulating material.

3. The connector assembly having a liquid cooling function according to claim 1, wherein the electrical connection framework (2) is electrically connected to the connection terminal by means of welding or crimping.

4. The connector assembly having a liquid cooling function according to claim 1, wherein a material of the protective shell (5) contains a rigid conductive material.

5. The connector assembly having a liquid cooling function according to claim 1, wherein
an impedance between the protective shell (5) and the shielding inner shell (4) is less than 80 mΩ; or
a transfer impedance of the protective shell (5) is less than 100 mΩ; or
a transfer impedance of the shielding inner shell (4) is less than 100 mΩ.

6. The connector assembly having a liquid cooling function according to claim 1, wherein the connector comprises a first connector (11) and a second connector (12) which are connected to two ends of the electrical connection framework (2), and the first connector (11) is internally provided with a rotary cavity (94) communicated with the cavity (6) and the hollow inner cavity (3); and
the second connector (12) is internally provided with an adapter cavity (95) communicated with the cavity (6), the electrical connection framework (2) is provided with an inlet pipe (91) communicated with the hollow inner cavity (3), and the second connector (12) is provided with an outlet pipe (92) communicated with the adapter cavity (95).

7. The connector assembly having a liquid cooling function according to claim 6, wherein a part of the electrical connection framework (2) inside the rotary cavity (94) is radially provided with a through hole (93), via which the cooling liquid flows through the hollow inner cavity (3) and the rotary cavity (94).

8. The connector assembly having a liquid cooling function according to claim 6, wherein a part of the electrical connection framework (2) inside the adapter cavity (95) is radially provided with a connection hole, into which the inlet pipe (91) is inserted and communicated with the hollow inner cavity (3), and the inlet pipe (91) passes through an outer wall of the second connector (12) and protrudes out of the second connector (12).

9. The connector assembly having a liquid cooling function according to claim 8, wherein a first sealing structure is disposed between the inlet pipe (91) and the second connector (12) and between the outlet pipe (91) and the second connector (12), or a second sealing structure is disposed between the connector and the protective shell (5).

10. The connector assembly having a liquid cooling function according to claim 1, wherein the cavity (6) is internally provided with at least one supporting ring (10), an inner wall of which is in contact with the outer periphery of the electrical connection framework (2), and an outer wall of which is in contact with the inner wall of the protective shell (5).

11. The connector assembly having a liquid cooling function according to claim 10, wherein the supporting ring (10) is provided with at least one axial through hole (101) in an axial direction of the electrical connection framework (2); or
the electrical connection framework (2) has a bent position, and at least two ends and a middle position of the arc shape are provided with the supporting rings (10), respectively.

12. The connector assembly having a liquid cooling function according to claim 1, wherein a thickness of the protective shell (5) accounts for 1% to 15% of an outer diameter of the protective shell (5); or
an outer diameter of the cavity (6) is 1.02 to 1.3 times that of the electrical connection framework (2); or
a boiling point of the cooling liquid is greater than or equal to 100°C; or
a cooling rate of the cooling liquid to the electrical connection framework (2) is 0.04 K/s to 6 K/s.

13. The connector assembly having a liquid cooling function according to claim 1, wherein one of the connectors is a charging cradle; or
a partial region of the electrical connection framework (2) is flexible; or
the electrical connection framework (2) comprises at least one bent portion.

14. A vehicle, comprising the connector assembly having a liquid cooling function according to any one of claims 1 to 13, a circulating pump and a cooling device, wherein the cavity (6) and the hollow inner cavity (3) are communicated with the circulating pump and the cooling device.

15. The vehicle according to claim 14, wherein an inlet pipe (91) in communication with the hollow inner cavity (3) is communicated with a liquid inlet of the circulating pump, a liquid outlet of the circulating pump is communicated with a liquid inlet of the cooling device, and an outlet pipe (92) in communication with the hollow inner cavity (3) is communicated with a liquid outlet of the cooling device.

## Patentansprüche

1. Verbinderanordnung mit einer Flüssigkeitskühlfunktion, aufweisend mindestens ein elektrisches Verbindungsgerüst (2) und Steckverbinder, wobei jeder Steckverbinder eine Anschlussklemme aufweist, zwei Enden des elektrischen Verbindungsgerüsts (2) jeweils elektrisch mit den Anschlussklemmen verbunden sind, das elektrische Verbindungsgerüst (2) mit einem hohlen Innenraum (3) versehen ist, ein Außenumfang des elektrischen Verbindungsgerüsts (2) mit einer Schutzhülle (5) ummantelt ist, die eine elektromagnetische Abschirmwirkung aufweist, zwischen dem Außenumfang des elektrischen Verbindungsgerüsts (2) und einer Innenwand der Schutzhülle (5), die eine elektromagnetische Abschirmwirkung aufweist, ein Hohlraum (6) ausgebildet ist, und der hohle Innenraum (3) sowie der Hohlraum (6) so ausgebildet sind, dass eine Kühlflüssigkeit durch sie hindurchströmen kann;
wobei
das elektrische Verbindungsgerüst (2) einen starren Hohlleiter aufweist;
der Steckverbinder ferner eine abschirmende Innenhülle (4) aufweist und ein Material der abschirmenden Innenhülle (4) ein leitfähiges Material enthält;
und die Schutzhülle (5) mittels Crimpen oder Schweißen elektrisch mit der abschirmenden Innenhülle (4) verbunden ist.

2. Verbinderanordnung mit einer Flüssigkeitskühlfunktion nach Anspruch 1, bei der die Kühlflüssigkeit aus einem isolierenden Material besteht.

3. Verbinderanordnung mit einer Flüssigkeitskühlfunktion nach Anspruch 1, bei der das elektrische Verbindungsgerüst (2) mittels Schweißen oder Crimpen elektrisch mit der Anschlussklemme verbunden ist.

4. Verbinderanordnung mit einer Flüssigkeitskühlfunktion nach Anspruch 1, bei der ein Material der Schutzhülle (5) ein starres leitfähiges Material enthält.

5. Verbinderanordnung mit einer Flüssigkeitskühlfunktion nach Anspruch 1, bei der
eine Impedanz zwischen der Schutzhülle (5) und der abschirmenden Innenhülle (4) weniger als 80 mΩ beträgt; oder
eine Übertragungsimpedanz der Schutzhülle (5) kleiner als 100 mΩ ist; oder
eine Übertragungsimpedanz der abschirmenden Innenhülle (4) weniger als 100 mΩ beträgt.

6. Verbinderanordnung mit einer Flüssigkeitskühlfunktion nach Anspruch 1, bei der der Steckverbinder einen ersten Steckverbinder (11) und einen zweiten Steckverbinder (12) aufweist, die mit zwei Enden des elektrischen Verbindungsgerüsts (2) verbunden sind, und der erste Steckverbinder (11) im Inneren mit einem Drehhohlraum (94) versehen ist, der mit dem Hohlraum (6) und dem hohlen Innenraum (3) in Verbindung steht; und
der zweite Steckverbinder (12) im Inneren mit einem Adapterhohlraum (95) versehen ist, der mit dem Hohlraum (6) in Verbindung steht, das elektrische Verbindungsgerüst (2) mit einem Einlassrohr (91) versehen ist, das mit dem hohlen Innenraum (3) in Verbindung steht, und der zweite Steckverbinder (12) mit einem Auslassrohr (92) versehen ist, das mit dem Adapterhohlraum (95) in Verbindung steht.

7. Verbinderanordnung mit einer Flüssigkeitskühlfunktion nach Anspruch 6, bei der ein Teil des elektrischen Verbindungsgerüsts (2) innerhalb des Drehhohlraums (94) radial mit einer Durchgangsbohrung (93) versehen ist, durch die die Kühlflüssigkeit durch den hohlen Innenraum (3) und den Drehhohlraum (94) fließt.

8. Verbinderanordnung mit einer Flüssigkeitskühlfunktion nach Anspruch 6, bei der ein Teil des elektrischen Verbindungsgerüsts (2) innerhalb des Adapterhohlraums (95) radial mit einer Verbindungsbohrung versehen ist, in die das Einlassrohr (91) eingeführt ist und die mit dem hohlen Innenraum (3) in Verbindung steht, und das Einlassrohr (91) eine Außenwand des zweiten Steckverbinders (12) durchdringt und aus dem zweiten Steckverbinder (12) herausragt.

9. Verbinderanordnung mit einer Flüssigkeitskühlfunktion nach Anspruch 8, bei der eine erste Dichtungsstruktur zwischen dem Einlassrohr (91) und dem zweiten Steckverbinder (12) sowie zwischen dem Auslassrohr (91) und dem zweiten Steckverbinder (12) angeordnet ist oder eine zweite Dichtungsstruktur zwischen dem Steckverbinder und der Schutzhülle (5) angeordnet ist.

10. Verbinderanordnung mit einer Flüssigkeitskühlfunktion nach Anspruch 1, bei der der Hohlraum (6) im Inneren mit mindestens einem Stützring (10) versehen ist, dessen Innenwand mit dem Außenumfang des elektrischen Verbindungsgerüsts (2) in Kontakt steht und dessen Außenwand mit der Innenwand der Schutzhülle (5) in Kontakt steht.

11. Verbinderanordnung mit einer Flüssigkeitskühlfunktion nach Anspruch 10, bei der der Stützring (10) mit mindestens einem axialen Durchgangsloch (101) in axialer Richtung des elektrischen Verbindungsgerüsts (2) versehen ist; oder
das elektrische Verbindungsgerüst (2) eine gebogene Form aufweist und an mindestens zwei Enden sowie in der Mitte der Bogenform jeweils Stützringe (10) vorgesehen sind.

12. Verbinderanordnung mit einer Flüssigkeitskühlfunktion nach Anspruch 1, bei der die Dicke der Schutzhülle (5) 1 % bis 15 % des Außendurchmessers der Schutzhülle (5) beträgt; oder
der Außendurchmesser des Hohlraums (6) das 1,02- bis 1,3-fache des Außendurchmessers des elektrischen Verbindungsgerüsts (2) beträgt; oder
der Siedepunkt der Kühlflüssigkeit größer oder gleich 100 °C ist; oder
die Kühlrate der Kühlflüssigkeit gegenüber dem elektrischen Verbindungsgerüst (2) 0,04 K/s bis 6 K/s beträgt.

13. Verbinderanordnung mit einer Flüssigkeitskühlfunktion nach Anspruch 1, bei der einer der Steckverbinder eine Ladestation ist; oder
ein Teilbereich des elektrischen Verbindungsgerüsts (2) flexibel ist; oder
das elektrische Verbindungsgerüst (2) mindestens einen gebogenen Abschnitt aufweist.

14. Fahrzeug, aufweisend die Verbinderanordnung mit einer Flüssigkeitskühlfunktion gemäß einem der Ansprüche 1 bis 13, eine Umwälzpumpe und eine Kühlvorrichtung, wobei der Hohlraum (6) und der hohle Innenraum (3) mit der Umwälzpumpe und der Kühlvorrichtung in Verbindung stehen.

15. Fahrzeug nach Anspruch 14, bei dem ein mit dem hohlen Innenraum (3) in Verbindung stehendes Einlassrohr (91) mit einem Flüssigkeitseinlass der Umwälzpumpe verbunden ist, ein Flüssigkeitsauslass der Umwälzpumpe mit einem Flüssigkeitseinlass der Kühlvorrichtung verbunden ist und ein mit dem hohlen Innenraum (3) in Verbindung stehendes Auslassrohr (92) mit einem Flüssigkeitsauslass der Kühlvorrichtung verbunden ist.

## Revendications

1. Ensemble de connecteurs à fonction de refroidissement par liquide, comprenant au moins une structure de connexion électrique (2) et des connecteurs, chaque connecteur comportant une borne de connexion, les deux extrémités de la structure de connexion électrique (2) étant respectivement reliées électriquement aux bornes de connexion, la structure de connexion électrique (2) étant pourvue d'un espace intérieur creux (3), une périphérie extérieure de la structure de connexion électrique (2) est recouverte d'une gaine de protection (5) qui présente un effet de blindage électromagnétique, une cavité (6) est formée entre la périphérie extérieure de la structure de connexion électrique (2) et une paroi intérieure de la gaine de protection (5), qui présente un effet de blindage électromagnétique, et la cavité (6) est formé de telle sorte qu'un liquide de refroidissement puisse circuler à travers eux;
dans lequel
la structure de connexion électrique (2) comprend un guide d'ondes rigide;
le connecteur comporte en outre une gaine intérieure de blindage (4) et le matériau de la gaine intérieure de blindage (4) contient un matériau conducteur;
et la gaine de protection (5) est reliée électriquement à la gaine intérieure de blindage (4) par sertissage ou soudage.

2. Ensemble de connecteurs à fonction de refroidissement par liquide selon la revendication 1, dans lequel le liquide de refroidissement est constitué d'un matériau isolant.

3. Ensemble de connecteurs à fonction de refroidissement par liquide selon la revendication 1, dans lequel la structure de connexion électrique (2) est reliée électriquement à la borne de connexion par soudage ou sertissage.

4. Ensemble de connecteurs à fonction de refroidissement par liquide selon la revendication 1, dans lequel un matériau de la gaine de protection (5) contient un matériau conducteur rigide.

5. Ensemble de connecteurs à fonction de refroidissement par liquide selon la revendication 1, dans lequel
l'impédance entre la gaine de protection (5) et la gaine intérieure de blindage (4) est inférieure à 80 mΩ ; ou
l'impédance de transmission de la gaine de protection (5) est inférieure à 100 mΩ ; ou l'impédance de transmission de la gaine intérieure de blindage (4) est inférieure à 100 mΩ.

6. Ensemble de connecteurs à fonction de refroidissement par liquide selon la revendication 1, dans lequel les connecteurs comprend un premier connecteur (11) et un deuxième connecteur (12) qui sont reliés aux deux extrémités de la structure de connexion électrique (2), et dans lequel le premier connecteur (11) est muni à l'intérieur d'une cavité rotative (94) qui communique avec la cavité (6) et l'espace intérieur creux (3) ; et
le deuxième connecteur (12) est muni à l'intérieur d'une cavité d'adaptation (95) qui communique avec la cavité (6), la structure de connexion électrique (2) est munie d'un tube d'entrée (91) qui communique avec l'espace intérieur creux (3), et le deuxième connecteur (12) est muni d'un tube de sortie (92) qui communique avec la cavité d'adaptation (95).

7. Ensemble de connecteurs à fonction de refroidissement par liquide selon la revendication 6, dans lequel une partie de la structure de connexion électrique (2) située à l'intérieur de la cavité rotative (94) est pourvue, dans le sens radial, d'un trou traversant (93) à travers lequel le liquide de refroidissement s'écoule à travers l'espace intérieur creux (3) et la cavité rotative (94).

8. Ensemble de connecteurs à fonction de refroidissement par liquide selon la revendication 6, dans lequel une partie de la structure de connexion électrique (2) est pourvue, à l'intérieur de la cavité d'adaptateur (95), d'un alésage de connexion radial dans lequel est introduit le tube d'entrée (91) et qui communique avec l'espace intérieur creux (3), et le tube d'entrée (91) traverse une paroi extérieure du deuxième connecteur (12) et fait saillie hors du deuxième connecteur (12).

9. Ensemble de connecteurs à fonction de refroidissement par liquide selon la revendication 8, dans lequel une première structure d'étanchéité est disposée entre le tube d'entrée (91) et le deuxième connecteur (12) ainsi qu'entre le tube de sortie (91) et le deuxième connecteur (12), ou une deuxième structure d'étanchéité est disposée entre le connecteur et la gaine de protection (5).

10. Ensemble de connecteurs à fonction de refroidissement par liquide selon la revendication 1, dans lequel la cavité (6) est pourvue à l'intérieur d'au moins une bague de support (10) dont la paroi intérieure est en contact avec la périphérie extérieure de la structure de connexion électrique (2) et dont la paroi extérieure est en contact avec la paroi intérieure de la gaine de protection (5).

11. Ensemble de connecteurs à fonction de refroidissement par liquide selon la revendication 10, dans lequel la bague de support (10) est pourvue d'au moins un trou traversant axial (101) dans la direction axiale de la structure de connexion électrique (2); ou
la structure de connexion électrique (2) présente une forme courbée et des bagues de support (10) sont prévues à au moins deux extrémités ainsi qu'au milieu de la courbe.

12. Ensemble de connecteurs à fonction de refroidissement par liquide selon la revendication 1, dans lequel l'épaisseur de la gaine de protection (5) est comprise entre 1 % et 15 % du diamètre extérieur de la gaine de protection (5); ou
le diamètre extérieur de la cavité (6) est compris entre 1,02 et 1,3 fois le diamètre extérieur de la structure de connexion électrique (2); ou
le point d'ébullition du liquide de refroidissement est supérieur ou égal à 100 °C; ou
le taux de refroidissement du liquide de refroidissement par rapport à la structure de connexion électrique (2) est compris entre 0,04 K/s et 6 K/s.

13. Ensemble de connecteurs à fonction de refroidissement par liquide selon la revendication 1, dans lequel l'un des connecteurs est une station de recharge; ou
une partie de la structure de connexion électrique (2) est flexible; ou
la structure de connexion électrique (2) comporte au moins une section courbée.

14. Véhicule comprenant l'ensemble de connecteurs à fonction de refroidissement par liquide selon l'une des revendications 1 à 13, une pompe de circulation et un dispositif de refroidissement, la cavité (6) et l'espace intérieur creux (3) étant en communication avec la pompe de circulation et le dispositif de refroidissement.

15. Véhicule selon la revendication 14, dans lequel un tube d'entrée (91) communiquant avec l'espace intérieur creux (3) est relié à une entrée de liquide de la pompe de circulation, une sortie de liquide de la pompe de circulation est reliée à une entrée de liquide du dispositif de refroidissement et un tube de sortie (92) communiquant avec l'espace intérieur creux (3) est raccordé à une sortie de liquide du dispositif de refroidissement.
